# EUROPÄISCHE PATENTSCHRIFT

(11) **EP 1 796 217 B1**
(45) Veröffentlichungstag und Bekanntmachung des Hinweises auf die Patenterteilung: **09.03.2016**
(21) Anmeldenummer: 05026847.3
(22) Anmeldetag: 08.12.2005
(51) Int. Cl.: H01R 12/52, H05K 3/34, H05K 3/36, H01R 43/20, H01R 12/58, H01R 12/73, H01R 12/72

(54) **Verfahren zur Herstellung von elektrischen Verbindungen zwischen Leiterplatten**
Method for producing electrical connections between circuit boards
Procédé pour obtenir des connexions électriques entre circuits imprimés

(43) Veröffentlichungstag der Anmeldung: 13.06.2007
(73) Patentinhaber: Delphi Technologies, Inc., Troy, MI 48007 (US)
(72) Erfinder: Schmitz, Klaus-Dieter, 42553 Velbert (DE)
(74) Vertreter: Delphi France SAS

(56) Entgegenhaltungen:
- DE-U1- 9 203 996
- FR-A- 2 608 328
- US-A- 3 437 882
- US-A- 4 785 533
- US-A- 5 321 585
- US-A- 5 907 475

## Beschreibung

Die Erfindung betrifft ein Verfahren zur Herstellung von elektrischen Verbindungen zwischen zwei in einem Winkel zueinander angeordneten Leiterplatten. Sie betrifft ferner eine Anordnung aus zwei in einem Winkel zueinander angeordneten, elektrisch miteinander verbundenen Leiterplatten.

Die Oberflächenmontagetechnik (SMT, surface mounting technology) hat die bedrahtete Bestückungstechnik zwar bereits zu einem großen Teil abgelöst. Mit dem SMT-Prozess werden eine höhere Packungsdichte sowie niedrigere Gesamtkosten erreicht. In der Praxis gibt es jedoch immer noch bedrahtete Bauteile, beispielsweise Steckverbinder und ähnliches, die sich praktisch auf jeder SMT-Baugruppe befinden. So werden bisher bei der Herstellung von elektrischen Verbindungen zwischen zwei in einem Winkel zueinander angeordneten Leiterplatten so genannte, jeweils einen Kunststoffblock umfassende Header, Winkelstecker usw. eingesetzt. Die aufeinander und zueinander löttechnisch gefügten Teile wie beispielsweise Header/ Leiterplatte mit Elektronikteil und Leiterplatte mit Leistungs- und gegebenenfalls Relaisteil sind nicht direkt in der SMD-Technologie (SMD, surface mounted device) bestückbar. Zum Löten der Headerblöcke sind zusätzliche Lötprozesse wie beispielsweise Wellenlöten oder selektives Löten erforderlich, was entsprechend aufwändig ist. Zudem sind diese zusätzlich erforderlichen Lötprozesse in der Regel auch relativ fehleranfällig. Eine Massenanfertigung der betreffenden Leiterplatten sowie artverwandter Verbindungen ist daher erschwert bzw. mit relativ hohen Kosten verbunden.

Da beispielsweise für ein bleifreies Löten in der Regel höhere Temperaturen erforderlich sind, sind bei den bisher üblichen Verfahren zudem hochtemperaturbeständige Trägerwerkstoffe bzw. aufwändige Lötmechanismen mit einer vorangehenden Befestigung und Arretierung beispielsweise von Kunststoff-Winkelverbindern durch Schrauben oder Nieten an der den Elektronikteil umfassenden Leiterplatte usw. erforderlich. Zwangsläufig ist auch ein Einsatz einer Durchkontaktierungstechnik (THT, through hole technology) in Lotmasken erforderlich, was entsprechend einen hohen Personalaufwand für das Handling und die Kontrolle mit sich bringt. Problematisch ist insbesondere auch das betreffende Moduldesign mit entsprechend hohem Platzbedarf, Materialaufwand und Modulgewicht. Im Hinblick auf die Tauglichkeit für ein bleifreies Löten ist insbesondere auch der Einsatz von preiswerten Kunststoffen für den Headerblock problematisch.

In der DE 92 03 996 U1 ist bereits eine Anordnung aus zwei in einem Winkel zueinander angeordneten, elektrisch miteinander verbundenen Leiterplatten beschrieben, bei der eine erste der beiden Leiterplatten mit einzelnen elektrischen Kontaktelementen bestückt ist, die mit randständigen Abschnitten von auf einer Vorderseite der ersten Leiterplatte vorgesehenen Leiterbahnen verlötet sind. Eines der Kontaktelemente besitzt ein abgewinkeltes Befestigungsende, das von der Rückseite der ersten Leiterplatte her durch ein in dieser vorgesehenes Loch hindurchgesteckt und an der Vorderseite wieder mit einem randständigen Abschnitt einer Leiterbahn verlötet ist. Die elektrischen Kontaktelemente 3 sind jeweils als Einpressstifte ausgeführt, die in Kontaktlöcher der zweiten Leiterplatte eingepresst werden.

Der Erfindung liegt die Aufgabe zugrunde, ein verbessertes Verfahren sowie eine verbesserte Anordnung der eingangs genannten Art bereitzustellen, mit denen die zuvor erwähnten Nachteile beseitigt sind.

Diese Aufgabe wird erfindungsgemäß gelöst durch ein Verfahren zur Herstellung von elektrischen Verwindungen zwischen zwei in einem Winkel zueinander angeordneten Leiterplatten, bei dem eine erste der beiden Leiterplatten mit einzelnen elektrischen Kontaktelementen in Form von SMD-Bauteilen nach dem Pick & Place-Verfahren bestückt und verlötet wird und die elektrischen Kontaktelemente anschließend mit der zweiten Leiterplatte verlötet werden, wobei die elektrischen Kontaktelemente zumindest teilweise jeweils mit abgewinkelten Lötfahnen versehen sind, die durch in der ersten Leiterplatte vorgesehenen Lötlöcher gesteckt werden, die elektrischen Kontaktelemente zumindest teilweise einzeln und/oder zumindest teilweise in Gruppen in eine auf die erste Leiterplatte aufgebrachte Lötpaste gesetzt werden, die elektrischen Kontaktelemente nach einem Reflow-Verfahren mit der ersten Leiterplatte verlötet werden und der Vorgang des Bestückens der ersten Leiterplatte mit den elektrischen Kontaktelementen und des Verlötens dieser Kontaktelemente mit der ersten Leiterplatte direkt in die SMD-Linie integriert wird.

Aufgrund dieser Ausgestaltung ergibt sich ein wirtschaftlicheres, kostengünstigeres Verfahren, das insbesondere auch für eine Massenanfertigung geeignet ist. Die bisher erforderlichen zusätzlichen Lötprozesse wie beispielsweise der zusätzliche Wellenlötvorgang oder das Einpressen mit Infrastruktur usw. entfällt. Es ist auch kein Einsatz hochtemperaturbeständiger Trägerwerkstoffe mehr erforderlich. Ebenso entfallen die bisher erforderlichen aufwändigen Lötmechanismen mit vorangehender Befestigung und Arretierung von beispielsweise Winkelverbindern etc. Insgesamt wird Bauraum, Material und Modulgewicht eingespart.

Nachdem keine Header mehr erforderlich sind, entfällt auch das Problem des Einsatzes preiswerter Kunststoffe für die Headerblöcke. Auch Winkelkontakte sind nunmehr entbehrlich. Die erfindungsgemäße Kontaktierung bringt auch direkte Einsparungen im Material mit sich, was einen entscheidenden Faktor bezüglich der Stückliste darstellt. Die elektrischen Kontaktelemente können insbesondere auch relativ hohe Ströme führen. Zudem sind kurze Leitungswege möglich. Während beispielsweise die bisher üblichen Header ein besonderes System erfordern, können die erfindungsgemäßen Kontakte wie SMD-Teile in einem Arbeitsgang aufgebracht und verlötet werden. Letztlich ist problemlos auch ein bleifreies Löten möglich. Nachdem die bisher vorgesehenen Kunststoffblöcke- (Header) durch einfache Kontaktelemente ersetzt werden, ergibt sich auch eine bessere Recyclebarkeit.

Da der Vorgang des Bestückens der ersten Leiterplatte mit den elektrischen Kontaktelementen und des Verlötens dieser Kontaktelemente mit der ersten Leiterplatte direkt in die SMD-Linie integriert wird, ist um Bestücken keine besondere Bestückautomatik mehr erforderlich. Es genügt das bereits vorhandene SMT-Equipment.

Nach dem die elektrischen Kontaktelemente zumindest teilweise einzeln oder zumindest teilweise in Gruppen in eine Lotpaste gesetzt werden, ist es möglich, die elektrischen Kontaktelemente individuell oder in Gruppen gehäusefrei direkt in die auf die erste Leiterplatte aufgebrachte Lotpaste zu setzen und durch einen Reflow-Lötvorgang mit der ersten Leiterplatte zu verlöten. Es entfällt also das bisher erforderliche Befestigen der Header mittels Schrauben oder Nieten. Die erfindungsgemäß eingesetzten elektrischen Kontaktelemente sind selbsttragend.

Von Vorteil ist insbesondere auch, wenn die elektrischen Kontaktelemente zumindest teilweise jeweils durch ein Stanzteil gebildet sind.

Über die abgewinkelten Lötfahnen werden die Kontaktmitten ausgerichtet. Die Lötfahnen stecken zentrierend in den Bohr- oder Lötlöchern, wobei sie wesentlich auch den Leitungsquerschnitt in den Durchgangslöchern mit verstärken können. Eine solche Anordnung garantiert eine erhöhte Stromtragfähigkeit der erfindungsgemäßen Leiterplatten-Kontaktanbindung.

Gemäß einer bevorzugten praktischen Ausgestaltung des erfindungsgemäßen Verfahrens werden die elektrischen Kontaktelemente als Gurtware zugeführt.

Vorteilhafterweise werden die elektrischen Kontaktelemente mit der ersten Leiterplatte nach einem Durchkontaktierungs-Reflow-Verfahren verlötet (THT, through hole technology).

Von Vorteil ist insbesondere auch, wenn die elektrischen Kontaktelemente zumindest teilweise jeweils durch ein Stanzteil gebildet sind.

Bevorzugt sind die elektrischen Kontaktelemente zumindest teilweise jeweils als Flachkontakt ausgeführt.

Gemäß einer zweckmäßigen praktischen Ausgestaltung weist zumindest ein Teil der elektrischen Kontaktelemente jeweils eine Temperaturschleife auf. Mit einer solchen Temperaturschleife wird die Biegebelastung in der Lötverbindung weitgehend verhindert. Zudem ist, da ein jeweiliges elektrisches Kontaktelement ja mit einer Leiterbahn der Leiterplatte verlötet ist, für eine gute Wärmeverteilung und eine zusätzliche Wärmeabstrahlung gesorgt.

Bevorzugt ist die zweite Leiterplatte mit Lötlöchern versehen, in die die bereits mit der ersten Leiterplatte verlöteten elektrischen Kontaktelemente gesteckt werden. Dabei können die elektrischen Kontaktelementen insbesondere durch die Lötlöcher der zweiten Leiterplatte hindurch gesteckt werden.

Gemäß einer bevorzugten praktischen Ausgestaltung des erfindungsgemäßen Verfahrens werden die elektrischen Kontaktelemente durch selektives Löten mit der zweiten Leiterplatte verlötet. Dabei werden die elektrischen Kontaktelemente zweckmäßigerweise durch selektives Wellenlöten mit der zweiten Leiterplatte verlötet. Das selektive Löten erfolgt bevorzugt über einzelne Düsen.

Bevorzugt werden die beiden Leiterplatten in einem Winkel von etwa 90° zueinander angeordnet. Dabei kann sich insbesondere eine L-förmige Anordnung ergeben. Grundsätzlich sind jedoch auch andere Winkel denkbar.

Die erste Leiterplatte umfasst vorteilhafterweise einen Elektronikteil.

Die zweite Leiterplatte umfasst bevorzugt einen Leitungsteil, insbesondere einen Leistungs- und Relaisteil.

Die Bestückungs- und Lötvorgänge erfolgen bevorzugt automatisch.

Mit dem erfindungsgemäßen Verfahren lässt sich somit eine universelle SMD-Hochstrom-Verbindung zwischen zwei Leiterplatten herstellen. Dazu werden vorteilhafterweise SMT- und Pick & Place-fähige SMT-Einzelflachkontakte erzeugt und für eine Lötverbindung der beiden Leiterplatten eingesetzt, die beispielsweise einen Elektronikteil bzw. einen Leistungsund Reläisteil umfassen und beispielsweise als L-Anordnung in einem Winkel von vorzugsweise 90° zueinander angeordnet sein können. Die Kontakte werden einerseits mit der einen und andererseits mit der anderen Leiterplatte verlötet.

Mit dem beispielsweise in Form von Flachkontakten vorgesehenen Verbindern zwischen den beiden Leiterplatten stehen Materialquerschnitte zur Verfügung, die dem Konstrukteur der Hardware eine entsprechend höhere Stromtragfähigkeit der zwischen den beiden Leiterplatten erzeugten Verbindungen erlauben, wobei sich überdies Möglichkeiten für kostengünstigere und weiter verbesserte IBEC-Konstrukte eröffnen (IBEC, International Body Engineering Conference).

Die erfindungsgemäßen elektrischen Kontaktelemente können direkt als SMT-Bauteile aus dem Gurt- oder Filmtape gefördert und nach dem Collect & Place- oder Pick & Place-Verfahren z.B. auf die den Elektronikteil umfassende und mit Lotpaste versehene Leiterplatte aufgebracht und anschließend inline im SMD-Reflow-Ofen insbesondere nach dem THR-Prinzip verlötet werden (THR, through hole reflow). Durch eine Integration des Bestückungs- und Lötvorgangs direkt in die SMD-Linie wird der Fertigungsprozess insgesamt entsprechend vereinfacht. So ist zum Bestücken keine besondere Bestückautomatik mehr erforderlich. Es reicht das bereits vorhandene SMT-Equipment.

Die bisher erforderlichen speziellen Lötprozesse entfallen. Materialpuffer werden vermieden und es kann Bedien- und Servicepersonal eingespart werden. Der Materialdurchlauf in der Fabrik wird beschleunigt. Es wird also eine so genannte schlanke Fabrik ermöglicht. Die erfindungsgemäße Kontaktierung bringt eine direkte Einsparung im Material mit sich, was sich als entsprechender Faktor in der Stückliste bemerkbar macht. Die bisher erforderlichen temperaturunempfindlichen und insbesondere für ein bleifreies Löten entsprechend teuren Gehäusekunststoffe, beispielsweise für Header oder Winkelverbinder entfallen. Das Oberflächen-Finish kann nunmehr direkt für eine bleifreie Lötung ausgelegt werden. Es sind keine hochtemperaturbeständigen Kunststoffmaterialien mehr erforderlich.

Die elektrischen Kontaktelemente können individuell bzw. einzeln oder in Gruppen gehäusefrei direkt in die auf die erste Leiterplatte aufgebrachte Lotpaste gesetzt und nach dem Reflow-Verfahren gelötet werden. Die bisher erforderliche Header-Befestigung durch Verschrauben oder Vernieten entfällt. Die eingesetzten elektrischen Kontaktelemente sind bevorzugt selbst tragend.

Werden die jeweiligen elektrischen Kontaktelemente oder Lötstifte mit einer Temperaturschleife ausgeführt, so kann dadurch die Biegebelastung in der Lötverbindung verhindert werden. Indem insbesondere Flachkontakte mit den jeweiligen Leiterbahnen der Leiterplatte oder gedruckten Schaltung verlötet werden, ist für eine gute Wärmeverteilung und eine zusätzliche Wärmeabstrahlung gesorgt.

Die Ausrichtung der Kontaktmitten wird durch die abgewinkelten Lötfahnen sichergestellt. Diese stecken zentrierend in den Lot- oder Bohrlöchern und ermöglichen gleichzeitig eine Anbindung von auf der Rückseite der Leiterplatte verlegten Leiterbahnen. Zudem wird der Leitungsquerschnitt in den jeweiligen Durchgangsöffnungen deutlich verstärkt. Es ist somit insbesondere auch eine erhöhte Stromtragfähigkeit der erfindungsgemäßen Leiterplatten-Kontaktanbindung gewährleistet.

Mit dem erfindungsgemäßen Kontaktsystem ergibt sich insbesondere auch eine entsprechende Einsparung von Materialgewicht und teuren Kunststoffen, wodurch die Wirtschaftlichkeit insgesamt weiter erhöht wird. Mit dem erfindungsgemäßen Verfahren zur Herstellung einer Lötverbindung zwischen zwei Leiterplatten kann insbesondere auch ein spezieller THT-plus-Lötprozess eingespart werden.

Die erfindungsgemäße Anordnung aus zwei in einem Winkel zueinander angeordneten, elektrisch miteinander verbundenen Leiterplatten zeichnet sich entsprechend dadurch aus, dass eine erste der beiden Leiterplatten mit einzelnen elektrischen Kontaktelementen in Form von SMD-Bauteilen bestückt und verlötet ist und die elektrischen Kontaktelemente zudem mit der zweiten Leiterplatte verlötet sind, wobei die elektrischen Kontaktelemente zumindest teilweise jeweils mit abgewinkeltem Lötfaden versehen sind, die durch in der ersten Leiterplatte vorgesehene Lötlöcher gesteckt sind.

Das erfindungsgemäße Kontaktierungsprinzip ermöglicht vor allem auch eine problemlose Umstellung insbesondere auf eine bleifreie Löttechnologie und eine sortenreine Rückgewinnung der Kontaktwerkstoffe zu 100 %.

Bevorzugte Ausführungsformen dieser erfindungsgemäßen Anordnung sind in den Unteransprüchen angegeben.

Die Erfindung wird im Folgenden anhand von Ausführungsbeispielen unter Bezugnahme auf die Zeichnung näher erläutert; in dieser zeigen:
- Fig. 1: eine schematische Teildarstellung zweier in einem Winkel von 90° zueinander angeordneter Leiterplatten,
- Fig. 2: eine schematische Teilansicht einer Mehrzahl von als Gurtware bereitgestellten elektrischen Kontaktelementen,
- Fig. 3: eine Draufsicht eines Stanzstreifens zur Bildung eines einzelnen elektrischen Kontaktelements,
- Fig. 4: eine Draufsicht eines aus dem Stanzstreifen gemäß Fig. 3 erhaltenen elektrischen Kontaktelements mit abgewinkelten Lötfahnen,
- Fig. 5: eine Seitenansicht eines Kontaktelements mit abgewinkelten Lötfahnen,
- Fig. 6: eine Seitenansicht eines mit einer Temperaturschleife versehenen Kontaktelements,
- Fig. 7: eine einer Leiterbahn der ersten Leiterplatte zugeordnete Anschlussfläche mit Lötlöchern und stellenweise aufgebrachter Lotpaste,
- Fig. 8: eine der zweiten Leiterplatte zugeordnete Anschlussfläche mit einem von einem elektrischen Kontaktelement durchsetzten Lötloch,
- Fig. 9: eine schematische Darstellung verschiedener Schritte bei der Herstellung der elektrischen Verbindungen zwischen den beiden Leiterplatten und
- Fig. 10: eine weitere schematische Darstellung verschiedener Schritte bei der Herstellung der elektrischen Verbindungen zwischen den beiden Leiterplatten.

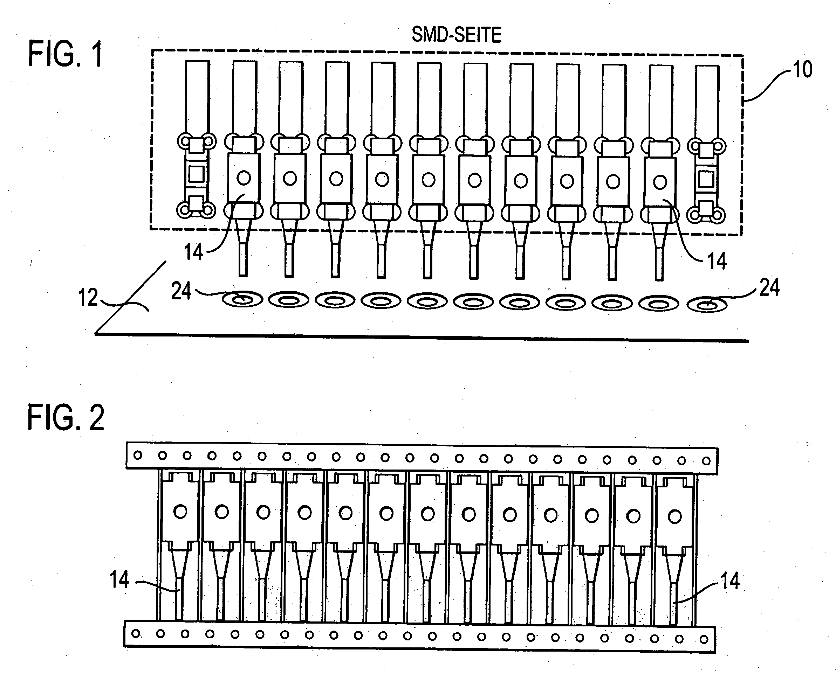

Fig. 1 zeigt in schematischer Teildarstellung zwei in einem Winkel von 90° zueinander angeordnete Leiterplatten 10, 12. Dabei umfasst im vorliegenden Fall die erste Leiterplatte 10 einen Elektronikteil. Es kann sich also beispielsweise um einen Signalauswertemodul oder dergleichen handeln. Die zweite Leiterplatte 12 umfasst einen Leistungsteil oder Leistungs- und Relaisteil. Hierbei kann es sich also beispielsweise um eine Steuer- und Relais-Box oder dergleichen handeln.

Zur Herstellung von elektrischen Verbindungen zwischen den beiden Leiterplatten 10, 12 sind einzelne elektrische Kontaktelemente 14 vorgesehen.

Dabei wird im vorliegenden Fall die erste Leiterplatte 10 mit den einzelnen elektrischen Kontaktelementen 14 in Form von SMD-Bauteilen nach dem Pick & Place-Verfahren bestückt und verlötet. Anschließend werden diese elektrischen Kontaktelemente 14 mit der zweiten Leiterplatte 12 verlötet.

In dieser Fig. 1 ist die SMD-Seite der den Elektronikteil umfassenden Leiterplatte 10 zu sehen.

Fig. 2 zeigt in schematischer Teilansicht eine Mehrzahl von als Gurtware bereitgestellten elektrischen Kontaktelementen 14. Die Bestückung der Leiterplatte 10 mit dem als Gurtware zugeführten elektrischen Kontaktelementen 14 kann also nach dem SMT-Verfahren automatisch erfolgen.

Mit der ersten Leiterplatte 10 werden die elektrischen Kontaktelemente 14 nach einem Reflow-Verfahren, im vorliegenden Fall nach einem Durchkontaktierungs-Reflow-Verfahren verlötet. Dabei wird der Vorgang des Bestückens dieser ersten Leiterplatte 10 mit den elektrischen Kontaktelementen 14 und des Verlötens dieser Kontaktelemente 14 mit der ersten Leiterplatte 10 direkt in die SMD-Linie integriert.

Die elektrischen Kontaktelemente 14 können individuell bzw. einzeln oder auch in Gruppen in die auf die Leiterplatte 10 aufgebrachte Lotpaste gesetzt werden.

Die elektrischen Kontaktelemente 14 sind jeweils durch ein Stanzteil gebildet und jeweils als Flachkontakt ausgeführt.

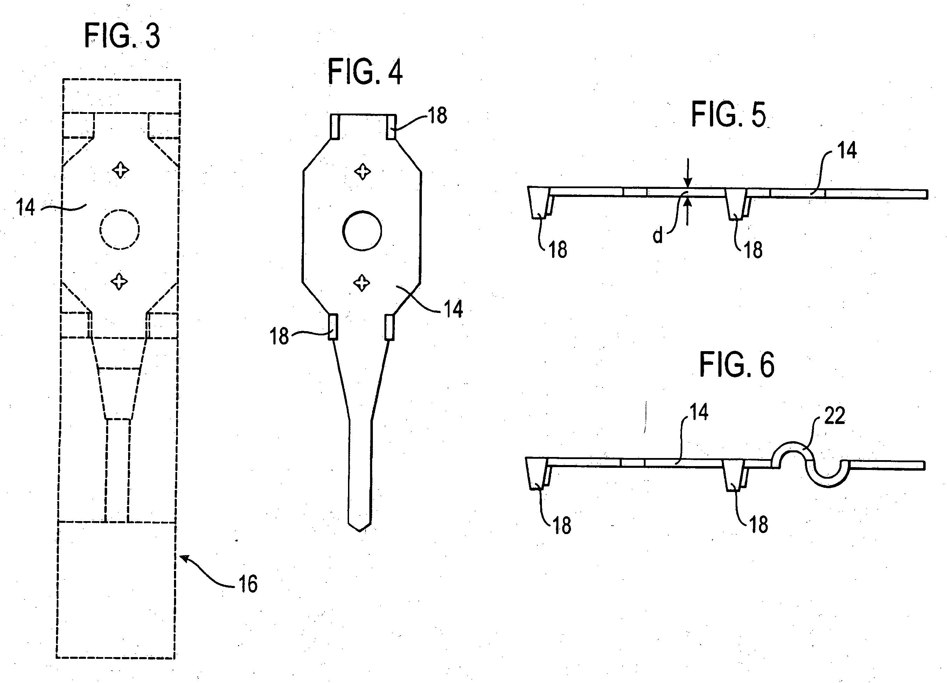

Fig. 3 zeigt in schematischer Draufsicht einen Stanzstreifen 16 zur Bildung eines solchen einzelnen elektrischen Kontaktelements 14. In der Draufsicht der Fig. 4 ist das aus dem Stanzstreifen 16 gemäß Fig. 3 erhaltene elektrische Kontaktelement 14 mit abgewinkelten Lötfahnen 18 dargestellt. In Fig. 5 ist das aus dem Stanzstreifen erhaltene Kontaktelement 14 mit abgewinkelten Lötfahnen 18 nochmals in Seitenansicht wiedergegeben.

Die Dicke d eines jeweiligen elektrischen Kontaktelements 14 beträgt im vorliegenden Fall beispielsweise 0,8 mm. Grundsätzlich ist jedoch auch eine andere Dicke möglich. Bevorzugt sind das Kontaktmaterial sowie die Kontaktdicke d so gewählt, dass sich ein selbst tragendes Kontaktelement 14 ergibt.

Im vorliegenden Fall besitzen die elektrischen Kontaktelemente 14 jeweils vier Lötfahnen 18.

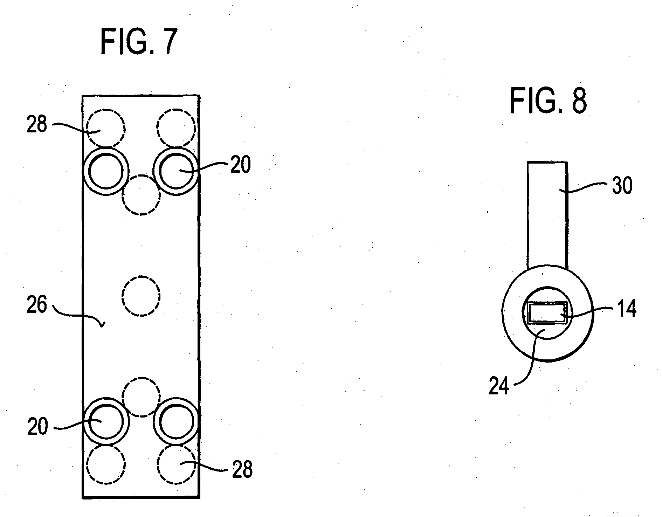

Die Lötfahnen 18 der elektrischen Kontaktelemente 14 werden durch in der ersten Leiterplatte 10 vorgesehene Lötlöcher 20 gesteckt (vgl. insbesondere auch Fig. 7). Dabei können sich die Lötfahnen 18 mit ihren freien Enden aus den Lötlöchern 20 heraus nach außen erstrecken. Über diese Lötfahnen 18 ist also zumindest teilweise auch eine Anbindung von auf der Rückseite der Leiterplatte 10 vorgesehenen Leiterbahnen möglich.

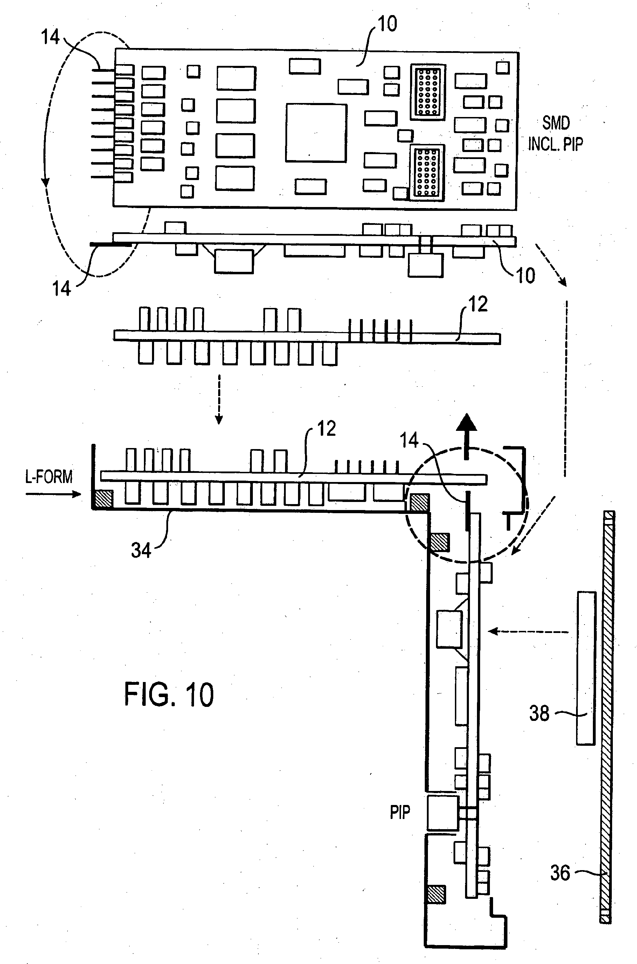

Zumindest ein Teil der elektrischen Kontaktelemente 14 kann auch jeweils mit einer Temperaturschleife versehen sein. Fig. 10 zeigt in Seitenansicht ein eine solche Temperaturschleife 22 aufweisendes elektrisches Kontaktelement 14. In der Darstellung dieser Fig. 6 sind auch wieder die abgewinkelten Lötfahnen 18 zu erkennen.

Die zweite Leiterplatte 12 ist mit Lötlöchern 24 versehen (vgl. insbesondere Fig. 1), in die die bereits mit der ersten Leiterplatte 10 verlöteten elektrischen Kontaktelemente 14 gesteckt werden. Dabei können die elektrischen Kontaktelemente 14 durch die Lötlöcher 24 der Leiterplatte 12 hindurch gesteckt werden.

Mit der zweiten Leiterplatte 12 werden die elektrischen Kontaktelemente 14 durch selektives Löten, vorzugsweise durch selektives Wellenlöten verlötet. Dabei kann das selektive Löten insbesondere über einzelne Düsen erfolgen.

Die betreffenden Bestückungs- und Lötvorgänge erfolgen bevorzugt automatisch.

Die beiden Leiterplatten 10, 12 können insbesondere L-förmig angeordnet sein bzw. eine L-förmige Anordnung bilden. Dabei kann beispielsweise die den Leistungs- und Relaisteil umfassende Leiterplatte kürzer sein als die den Elektronikteil umfassende Leiterplatte. Bevorzugt werden die beiden Leiterplatten im Bereich von Schmalseiten miteinander elektrisch verbunden (vgl. z.B. Fig. 10).

Fig. 7 zeigt eine einer Leiterbahn der ersten Leiterplatte (vgl. beispielsweise auch Fig. 1) zugeordnete Anschlussfläche 26 mit z.B. vier Lötlöchern 20 für die Lötfahnen 18 der elektrischen Kontaktelemente 14. Wie anhand dieser Fig. 7 zu erkennen ist, ist auf diese vorzugsweise aus Kupfer bestehende Anschlussfläche 26 stellenweise Lotpaste 28 aufgebracht. Es kann also insbesondere nach der so genannten Pin-in-Paste-Technik vorgegangen werden, wobei allerdings nicht die Lötlöcher 20, sondern diesen benachbarte Bereiche der Anschlussfläche 26 mit Lotpaste versehen werden.

Wie anhand der Fig. 7 zu erkennen ist, wird auch im mittleren Bereich der Anschlussfläche 26 Lotpaste aufgetragen. Beim Lötvorgang gelangt dann Lotpaste durch die Kapillarwirkung in die Lotlöcher 20. Zudem wird die Lotpaste beim Löten zumindest-teilweise auch über die Anschlussfläche 26 verteilt.

Fig. 8 zeigt eine der zweiten Leiterplatte 12 (vgl. insbesondere auch Fig. 1) zugeordnete Anschlussfläche 30 mit einem von einem elektrischen Kontaktelement 14 durchsetzten Lötloch 24. Auch diese Anschlussfläche 30 besteht vorzugsweise wieder aus Kupfer.

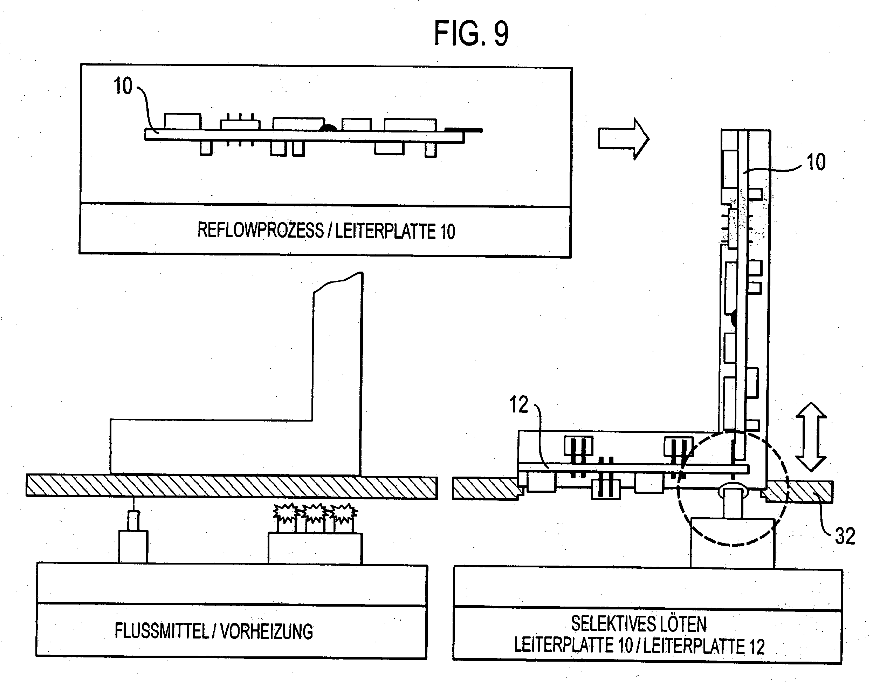

Fig. 9 zeigt in schematischer Darstellung nochmals verschiedene Schritte bei der Herstellung der elektrischen Verbindungen zwischen den beiden Leiterplatten 10, 12.

So ist im oberen linken Teil dieser Fig. 9 nochmals der Reflow-Prozess angedeutet, dem die erste Leiterplatte 10 unterzogen wird. Im linken unteren Teil der Fig. 9 ist bereits die L-förmige Anordnung der beiden Leiterplatten zu erkennen. Es wird von unten Flussmittel zugeführt, und es erfolgt eine Vorheizung. Dabei wird, wie der Fig. 9 entnommen werden kann, nur von unten vorgeheizt.

Im rechten unteren Teil der Fig. 9 ist nochmals der Verfahrensabschnitt des selektiven Lötens angedeutet. Dabei ist unter anderem auch eine Lotmaske 32 zu erkennen.

Fig. 10 zeigt eine weitere schematische Darstellung verschiedener Schritte bei der Herstellung der elektrischen Verbindungen zwischen den beiden Leiterplatten 10, 12. Dabei ist die den Elektronikteil umfassende erste Leiterplatte 10 im oberen Teil der Fig. 10 in Draufsicht und unmittelbar darunter nochmals in einer Seitenansicht wiedergegeben. An der linken Schmalseite dieser Leiterplatte 10 sind die mit dieser Leiterplatte 10 bereits verlöteten elektrischen Kontaktelemente 14 zu erkennen.

Zudem zeigt die Fig. 10, wie diese den Elektronikteil umfassende erste Leiterplatte 10 sowie die den Leistungs- und Relaisteil umfassende zweite Leiterplatte 12 zur Bildung einer L-förmigen Anordnung eingebaut werden.

Danach wird die ICT-geprüfte, den Elektronikteil umfassende erste Leiterplatte 10 in das Gehäuse 34 gefügt. Es wird ein Kühlblech 36 mit einem zugeordneten Polster 38 aus weichem Keramik/Kunststoff-Material eingelegt und verschraubt. Danach wird die den Leistungs- und Relaisteil umfassende zweite Leiterplatte 12 in das Gehäuse 34 gefügt. Dabei wird dafür gesorgt, dass die bereits mit der Leiterplatte 10 verlöteten elektrischen Kontaktelemente 14 in die betreffenden Lötlöcher oder Bohrungen 24 der Leiterplatte 12 gelangen. Die den Leistungs- und Relaisteil umfassende Leiterplatte 12 wird dann im Gehäuse 34 fixiert oder verschraubt (Träger). Danach wird die Lotmaske mit den Leiterplatten 10, 12 mit der L-Form-Box geladen. Schließlich werden die elektrischen Kontaktelemente 14 selektiv mit der den Leistungs- und Relaisteil umfassenden Leiterplatte 12 verlötet.

### Bezugszeichenliste

- 10: Leiterplatte
- 12: Leiterplatte
- 14: elektrisches Kontaktelement
- 16: Stanzstreifen
- 18: Lötfahne
- 20: Lötloch
- 22: Temperaturschleife
- 24: Lötloch
- 26: Anschlussfläche
- 28: Lötpaste
- 30: Anschlussfläche
- 32: Lotmaske
- 34: Gehäuse
- 36: Kühlblech
- 38: Polster

- d: Dicke

## Patentansprüche

1. Verfahren zur Herstellung von elektrischen Verbindungen zwischen zwei in einem Winkel zueinander angeordneten Leiterplatten (10, 12), bei dem eine erste (10) der beiden Leiterplatten (10, 12) mit einzelnen elektrischen Kontaktelementen (14) in Form von SMD-Bauteilen nach dem Pick & Place-Verfahren bestückt und verlötet wird und die elektrischen Kontaktelemente (14) anschließend mit der zweiten Leiterplatte (12) verlötet werden, wobei die elektrischen Kontaktelemente (14) zumindest teilweise jeweils mit abgewinkelten Lötfahnen (18) versehen sind, die durch in der ersten Leiterplatte (10) vorgesehene Lötlöcher (20) gesteckt werden, die elektrischen Kontaktelemente (14) zumindest teilweise einzeln und/oder zumindest teilweise in Gruppen in eine auf die erste Leiterplatte (10) aufgebrachte Lotpaste gesetzt werden, die elektrischen Kontaktelemente (14) nach einem Reflow-Verfahren mit der ersten Leiterplatte (10) verlötet werden und der Vorgang des Bestückens der ersten Leiterplatte (10) mit den elektrischen Kontaktelementen (14) und des Verlötens dieser Kontaktelemente (14) mit der ersten Leiterplatte (10) direkt in die SMD-Linie integriert wird.

2. Verfahren nach Anspruch 1,
**dadurch gekennzeichnet,**
**dass** die elektrischen Kontaktelemente (14) als Gurtware zugeführt werden.

3. Verfahren nach Anspruch 1 oder 2,
**dadurch gekennzeichnet,**
**dass** die elektrischen Kontaktelemente (14) nach einem Durchkontaktierungs-Reflow-Verfahren mit der ersten Leiterplatte (10) verlötet werden.

4. Verfahren nach einem der vorhergehenden Ansprüche,
**dadurch gekennzeichnet,**
**dass** die elektrischen Kontaktelemente (14) zumindest teilweise jeweils durch ein Stanzteil gebildet sind.

5. Verfahren nach einem der vorhergehenden Ansprüche,
**dadurch gekennzeichnet,**
**dass** die elektrischen Kontaktelemente (14) zumindest teilweise jeweils als Flachkontakt ausgeführt sind.

6. Verfahren nach einem der vorhergehenden Ansprüche,
**dadurch gekennzeichnet,**
**dass** sich die Lötfahnen (18) mit ihren freien Enden aus den Lötlöchern (20) heraus nach außen erstrecken.

7. Verfahren nach einem der vorhergehenden Ansprüche,
**dadurch gekennzeichnet,**
**dass** über die Lötfahnen (18) zumindest teilweise auch eine Anbindung von auf der Rückseite der ersten Leiterplatte (10) vorgesehenen Leiterbahnen erfolgt.

8. Verfahren nach einem der vorhergehenden Ansprüche,
**dadurch gekennzeichnet,**
**dass** zumindest ein Teil der elektrischen Kontaktelemente (14) jeweils eine Temperaturschleife (22) aufweist.

9. Verfahren nach einem der vorhergehenden Ansprüche,
**dadurch gekennzeichnet,**
**dass** die zweite Leiterplatte (12) mit Lötlöchern (24) versehen ist, in die die bereits mit der ersten Leiterplatte (10) verlöteten elektrischen Kontaktelemente (14) gesteckt werden.

10. Verfahren nach Anspruch 9,
**dadurch gekennzeichnet,**
**dass** die elektrischen Kontaktelemente (14) durch die Lötlöcher (24) der zweiten Leiterplatte (12) hindurch gesteckt werden.

11. Verfahren nach einem der vorhergehenden Ansprüche,
**dadurch gekennzeichnet,**
**dass** die elektrischen Kontaktelemente (14) durch selektives Löten mit der zweiten Leiterplatte (12) verlötet werden.

12. Verfahren nach Anspruch 11,
**dadurch gekennzeichnet,**
**dass** die elektrischen Kontaktelemente (14) durch selektives Wellenlöten mit der zweiten Leiterplatte (12) verlötet werden.

13. Verfahren nach Anspruch 11 oder 12,
**dadurch gekennzeichnet,**
**dass** das selektive Löten über einzelne Düsen erfolgt.

14. Verfahren nach einem der vorhergehenden Ansprüche,
**dadurch gekennzeichnet,**
**dass** die beiden Leiterplatten (10, 12) in einem Winkel von etwa 90° zueinander angeordnet werden.

15. Verfahren nach Anspruch 14,
**dadurch gekennzeichnet,**
**dass** die beiden Leiterplatten (10, 12) L-förmig angeordnet werden.

16. Verfahren nach einem der vorhergehenden Ansprüche,
**dadurch gekennzeichnet,**
**dass** die erste Leiterplatte (10) einen Elektronikteil umfasst.

17. Verfahren nach einem der vorhergehenden Ansprüche,
**dadurch gekennzeichnet,**
**dass** die zweite Leiterplatte (12) einen Leistungsteil umfasst.

18. Verfahren nach Anspruch 17,
**dadurch gekennzeichnet,**
**dass** die zweite Leiterplatte (12) einen Leistungs- und Relaisteil umfasst.

19. Verfahren nach einem der vorhergehenden Ansprüche,
**dadurch gekennzeichnet,**
**dass** die Bestückungs- und Lötvorgänge automatisch erfolgen.

20. Anordnung aus zwei in einem Winkel zueinander angeordneten, elektrisch miteinander verbundenen Leiterplatten (10, 12), bei der eine erste (10) der beiden Leiterplatten (10, 12) mit einzelnen elektrischen Kontaktelementen (14) in Form von SMD-Bauteilen bestückt und verlötet ist und die elektrischen Kontaktelemente (14) zudem mit der zweiten Leiterplatte (12) verlötet sind, wobei die elektrischen Kontaktelemente (14) zumindest teilweise jeweils mit abgewinkelten Lötfahnen (18) versehen sind, die durch in der ersten Leiterplatte (10) vorgesehene Lötlöcher (20) gesteckt sind.

21. Anordnung nach Anspruch 20,
**dadurch gekennzeichnet,**
**dass** die elektrischen Kontaktelemente (14) zumindest teilweise jeweils durch ein Stanzteil gebildet sind.

22. Anordnung nach Anspruch 20 oder 21,
**dadurch gekennzeichnet,**
**dass** die elektrischen Kontaktelemente (14) zumindest teilweise jeweils als Flachkontakt ausgeführt sind.

23. Anordnung nach einem der Ansprüche 20 bis 22,
**dadurch gekennzeichnet,**
**dass** sich die Lötfahnen (18) mit ihren freien Enden aus den Lötlöchern (20) heraus nach außen erstrecken.

24. Anordnung nach einem der Ansprüche 20 bis 23,
**dadurch gekennzeichnet,**
**dass** über die Lötfahnen (18) zumindest teilweise auch eine Anbindung von auf der Rückseite der ersten Leiterplatte (10) vorgesehenen Leiterbahnen erfolgt.

25. Anordnung nach einem der Ansprüche 20 bis 25,
**dadurch gekennzeichnet,**
**dass** zumindest ein Teil der elektrischen Kontaktelemente (14) jeweils eine Temperaturschleife (22) aufweist.

26. Anordnung nach einem der Ansprüche 20 bis 25,
**dadurch gekennzeichnet,**
**dass** die zweite Leiterplatte (12) mit Lötlöchern (24) versehen ist, in die die elektrischen Kontaktelemente (14) gesteckt sind.

27. Anordnung nach Anspruch 26,
**dadurch gekennzeichnet,**
**dass** sich die elektrischen Kontaktelemente (14) durch die Lötlöcher (24) der zweiten Leiterplatte (12) hindurch erstrecken.

28. Anordnung nach einem der Ansprüche 20 bis 27,
**dadurch gekennzeichnet,**
**dass** die beiden Leiterplatten (10, 12) in einem Winkel von etwa 90° zueinander angeordnet sind.

29. Anordnung nach Anspruch 28,
**dadurch gekennzeichnet,**
**dass** die beiden Leiterplatten (10, 12) L-förmig angeordnet sind.

30. Anordnung nach einem der Ansprüche 20 bis 29,
**dadurch gekennzeichnet,**
**dass** die erste Leiterplatte (10) einen Elektronikteil umfasst.

31. Anordnung nach einem der Ansprüche 20 bis 30,
**dadurch gekennzeichnet,**
**dass** die zweite Leiterplatte (12) einen Leistungsteil umfasst.

32. Anordnung nach Anspruch 31,
**dadurch gekennzeichnet,**
**dass** die zweite Leiterplatte (12) einen Leistungs- und Relaisteil umfasst.

## Claims

1. A method for manufacturing of electrical connections between two printed circuit boards (10, 12) arranged in an angle with respect to each other, wherein a first one (10) of the two printed circuit boards (10, 12) is fitted with individual electrical contact elements (14) in the form of SMD components according to the pick & place method and soldered and the electrical contact elements (14) are then soldered to the second printed circuit board (12), wherein the electrical contact elements (14) are at least partially provided with angled solder lugs (18) that are inserted through soldering holes (20) provided in the first printed circuit board (10), wherein the electrical contact elements (14) are placed at least partially individually and/or at least partially in groups in a soldering paste applied onto the first printed circuit board (10), wherein the electrical contact elements (14) are soldered to the first printed circuit board (10) according to a reflow process and said process of fitting the first printed circuit board (10) with the electrical contact elements (14) and said soldering of said contact elements (14) with the first printed circuit board (10) is directly integrated into the SMD line.

2. The method according to claim 1,
**characterized in that** the electrical contact elements (14) are supplied as belt element.

3. The method according to claim 1 or 2,
**characterized in that** the electrical contact elements (14) are soldered to the first printed circuit board (10) according to a through hole reflow process.

4. The method according to one of the preceding claims,
**characterized in that** the electrical contact elements (14) are at least partially formed by a die-cut part.

5. The method according to one of the preceding claims,
**characterized in that** the electrical contact elements (14) are at least partially formed as flat contact.

6. The method according to one of the preceding claims,
**characterized in that** the solder lugs (18) extend with their free ends through the soldering holes (20) to the outside.

7. The method according to one of the preceding claims,
**characterized in that** a connection by way of the solder lugs (18) of conducting paths provided on the rear side of the first printed circuit board (10) is also provided at least partially.

8. The method according to one of the preceding claims,
**characterized in that** at least part of the electrical contact elements (14) have a temperature loop (22).

9. The method according to one of the preceding claims,
**characterized in that** the second printed circuit board (12) is provided with soldering holes (24), in which the electrical contact elements (14) already soldered to the first printed circuit board (10) are inserted.

10. The method according to claim 9,
**characterized in that** the electrical contact elements (14) are inserted through the soldering holes (24) of the second printed circuit board (12).

11. The method according to one of the preceding claims,
**characterized in that** the electrical contact elements (14) are soldered to the second printed circuit board (12) by selective soldering.

12. The method according to claim 11,
**characterized in that** the electrical contact elements (14) are soldered to the second printed circuit board (12) by selective wave soldering.

13. The method according to claim 11 or 12,
**characterized in that** the selective soldering is performed via individual nozzles.

14. The method according to one of the preceding claims,
**characterized in that** the two printed circuit boards (10, 12) are arranged at an angle of about 90° to each other.

15. The method according to claim 14,
**characterized in that** the two printed circuit boards (10, 12) are arranged in L-shape.

16. The method according to one of the preceding claims,
**characterized in that** the first printed circuit board (10) includes an electronic unit.

17. The method according to one of the preceding claims,
**characterized in that** the second printed circuit board (12) includes a power unit.

18. The method according to claim 17,
**characterized in that** the second printed circuit board (12) includes a power and relay unit.

19. The method according to one of the preceding claims,
**characterized in that** the fitting and soldering processes are automatic.

20. Arrangement of two electrically connected printed circuit boards (10, 12) arranged in an angle with respect to each other, wherein a first one (10) of the two printed circuit boards (10, 12) is fitted with individual electrical contact elements (14) in the form of SMD components and soldered and the electrical contact elements (14) are then soldered to the second printed circuit board (12), wherein the electrical contact elements (14) each are at least partially provided with angled solder lugs (18) that are inserted through soldering holes (20) provided in the first printed circuit board (10).

21. Arrangement according to claim 20,
**characterized in that** the electrical contact elements (14) are at least partially formed by a die-cut part.

22. Arrangement according to claim 20 or 21,
**characterized in that** the electrical contact elements (14) are at least partially formed as flat contact.

23. Arrangement according to one of the claims 20 to 22,
**characterized in that** the solder lugs (18) extend with their free ends through the soldering holes (20) to the outside.

24. Arrangement according to one of the claims 20 to 23,
**characterized in that** a connection by way of the solder lugs (18) of conducting paths provided on the rear side of the first printed circuit board (10) is also provided at least partially.

25. Arrangement according to one of the claims 20 to 25,
**characterized in that** at least part of the electrical contact elements (14) have a temperature loop (22).

26. Arrangement according to one of the claims 20 to 25,
**characterized in that** the second printed circuit board (12) is provided with soldering holes (24), in which the electrical contact elements (14) are inserted.

27. Arrangement according to claim 26,
**characterized in that** the electrical contact elements (14) extend through the soldering holes (24) of the second printed circuit board (12).

28. Arrangement according to one of the claims 20 to 27,
**characterized in that** the two printed circuit boards (10, 12) are arranged at an angle of about 90° to each other.

29. Arrangement according to claim 28,
**characterized in that** the two printed circuit boards (10, 12) are arranged in L-shape.

30. Arrangement according to one of the claims 20 to 29,
**characterized in that** the first printed circuit board (10) includes an electronic unit.

31. Arrangement according to one of the claims 20 to 30,
**characterized in that** the second printed circuit board (12) includes a power unit.

32. Arrangement according to claim 31,
**characterized in that** the second printed circuit board (12) includes a power and relay unit.

## Revendications

1. Procédé pour établir des connexions électriques entre deux cartes à circuits (10, 12) agencées sous un angle l'une par rapport à l'autre, dans lequel une première (10) des deux cartes à circuits (10, 12) est équipée et brasée avec des éléments de contact électrique individuels (14) sous la forme de composants montés en surface "SMD" d'après la procédure dite "Pick & Place", et les éléments de contact électrique (14) sont ensuite brasés avec la seconde carte à circuits (12), dans lequel les éléments de contact électrique (14) sont au moins partiellement dotés respectivement de pattes de brasage (18) en angle, qui sont enfichées dans des trous de brasage (20) prévus dans la première carte à circuits (10), les éléments de contact électrique (14) sont placés au moins partiellement individuellement et/ou au moins partiellement par groupes dans une pâte de brasure appliquée sur la première carte à circuits (10), les éléments de contact électrique (14) sont brasés avec la première carte à circuits (10) d'après une procédure dite "Reflow", et la procédure d'équipement de la première carte à circuits (10) avec les éléments de contact électrique (14) et de brasage de ces éléments de contact (14) avec la première carte à circuits (10) est intégrée directement dans la ligne SMD.

2. Procédé selon la revendication 1,
**caractérisé en ce que** les éléments de contact électrique (14) sont amenés sous forme de produits en bande.

3. Procédé selon la revendication 1 ou 2,
**caractérisé en ce que** les éléments de contact électrique (14) sont brasés avec la première carte à circuits (10) d'après une procédure de mise en contact traversant et de Reflow.

4. Procédé selon l'une des revendications précédentes,
**caractérisé en ce que** les éléments de contact électrique (14) sont formés au moins partiellement chacun par une pièce estampée.

5. Procédé selon l'une des revendications précédentes,
**caractérisé en ce que** les éléments de contact électrique (14) sont réalisés au moins partiellement chacun sous forme de contacts plats.

6. Procédé selon l'une des revendications précédentes,
**caractérisé en ce que** les pattes de brasage (18) s'étendent vers l'extérieur avec leurs extrémités libres sortant hors des trous de brasage (20).

7. Procédé selon l'une des revendications précédentes,
**caractérisé en ce qu'**au moyen des pattes de brasage (18) il se produit au moins partiellement également une liaison de pistes conductrices prévues sur l'envers de la première carte à circuits (10).

8. Procédé selon l'une des revendications précédentes,
**caractérisé en ce qu'**au moins une partie des éléments de contact électrique (14) comportent chacun une boucle de température (22).

9. Procédé selon l'une des revendications précédentes,
**caractérisé en ce que** la seconde carte à circuits (12) est dotée de trous de brasage (24) dans lesquels sont enfichés les éléments de contact électrique (14) déjà brasés avec la première carte à circuits (10).

10. Procédé selon la revendication 9,
**caractérisé en ce que** les éléments de contact électrique (14) sont enfichés en traversant les trous de brasage (24) de la seconde carte à circuits (12).

11. Procédé selon l'une des revendications précédentes,
**caractérisé en ce que** les éléments de contact électrique (14) sont brasés avec la seconde carte à circuits (12) par brasage sélectif.

12. Procédé selon la revendication 11,
**caractérisé en ce que** les éléments de contact électrique (14) sont brasés avec la seconde carte à circuits (12) par brasage sélectif à la vague.

13. Procédé selon la revendication 11 ou 12,
**caractérisé en ce que** le brasage sélectif a lieu au moyen de buses individuelles.

14. Procédé selon l'une des revendications précédentes,
**caractérisé en ce que** les deux cartes à circuits (10, 12) sont agencées sous un angle d'environ 90° l'une par rapport à l'autre.

15. Procédé selon la revendication 14,
**caractérisé en ce que** les deux cartes à circuit (10, 12) sont agencés en formant un L.

16. Procédé selon l'une des revendications précédentes,
**caractérisé en ce que** la première carte à circuits (10) inclut une partie électronique.

17. Procédé selon l'une des revendications précédentes,
**caractérisé en ce que** la seconde carte à circuits (12) inclut une partie de puissance.

18. Procédé selon la revendication 17,
**caractérisé en ce que** la seconde carte à circuits (12) inclut une partie de puissance et de relais.

19. Procédé selon l'une des revendications précédentes,
**caractérisé en ce que** les procédures d'équipement et de brasage ont lieu automatiquement.

20. Agencement constitué de deux cartes à circuits (10, 12) agencées sous un angle l'une par rapport à l'autre et reliées électriquement l'une à l'autre, dans lequel une première (10) des deux cartes à circuits (10, 12) est équipée avec des éléments de contact électrique individuels (14) sous la forme de composants montés en surface SMD et brasée, et les éléments de contact électrique (14) sont en outre brasés avec la seconde carte à circuits (12), dans lequel les éléments de contact électrique (14) sont dotés au moins partiellement chacun de pattes de brasage (18) en angle, qui sont enfichées à travers des trous de brasage (20) prévus dans la première carte à circuits (10).

21. Agencement selon la revendication 20,
**caractérisé en ce que** les éléments de contact électrique (14) sont formés au moins partiellement chacun par une pièce estampée.

22. Agencement selon la revendication 20 ou 21,
**caractérisé en ce que** les éléments de contact électrique (14) sont réalisés au moins partiellement chacun comme un contact plat.

23. Agencement selon l'une des revendications 20 à 22,
**caractérisé en ce que** les pattes de brasage (18) s'étendent vers l'extérieur avec leurs extrémités libres sortant hors des trous de brasage (20).

24. Agencement selon l'une des revendications 20 à 23,
**caractérisé en ce qu'**au moyen des pattes de brasage (18) il se produit au moins partiellement également une liaison de pistes conductrices prévues sur l'envers de la première carte à circuits (10).

25. Agencement selon l'une des revendications 20 à 24,
**caractérisé en ce qu'**au moins une partie des éléments de contact électrique (14) comportent respectivement une boucle de température (22).

26. Agencement selon l'une des revendications 20 à 25,
**caractérisé en ce que** la seconde carte à circuits (12) est dotée de trous de brasage (24) dans lesquelles sont enfichés les éléments de contact électrique (14).

27. Agencement selon la revendication 26,
**caractérisé en ce que** les éléments de contact électrique (14) s'étendent en traversant les trous de brasage (24) de la seconde carte à circuits (12).

28. Agencement selon l'une des revendications 20 à 27,
**caractérisé en ce que** les deux cartes à circuits (10, 12) sont agencées sous un angle d'environ 90° l'une par rapport à l'autre.

29. Agencement selon la revendication 28,
**caractérisé en ce que** les deux cartes à circuits (10, 12) sont agencées en formant un L.

30. Agencement selon l'une des revendications 20 à 29,
**caractérisé en ce que** la première carte à circuits (10) inclut une partie électronique.

31. Agencement selon l'une des revendications 20 à 30,
**caractérisé en ce que** la seconde carte à circuits (12) inclut une partie de puissance.

32. Agencement selon la revendication 31,
**caractérisé en ce que** la seconde carte à circuits (12) inclut une partie de puissance et de relais.
